# EUROPEAN PATENT APPLICATION

(11) **EP 4 276 888 A1**
(43) Date of publication of application: **15.11.2023**
(21) Application number: 22172217.6
(22) Date of filing: 09.05.2022
(51) Int. Cl.: H01L 21/50, H01L 23/04, H01L 23/053, H01L 23/24, H01L 25/07, H01L 21/54, H01L 23/373, H01L 23/057, H01L 23/498

(54) **METHOD FOR PRODUCING A POWER SEMICONDUCTOR MODULE**

(71) Applicant: Infineon Technologies AG, 85579 Neubiberg (DE)
(72) Inventor: GOLDAMMER, Martin, 59494 Soest (DE); EHLERS, Carsten, 41066 Mönchengladbach (DE); NOLTEN, Ulrich, 59602 Rüthen (DE); STEININGER, Christian, 59494 Soest (DE)
(74) Representative: Westphal, Mussgnug & Partner, Patentanwälte mbB

(57) **Abstract**

A method comprises pouring a liquid, semi-liquid or viscous material into a cavity formed by sidewalls of a housing, thereby covering a substrate that is arranged in the cavity formed by the sidewalls, arranging a lid on the sidewalls, thereby covering the cavity formed by the sidewalls, wherein the lid comprises at least one functional element that extends from the lid into the liquid, semi-liquid or viscous material in a direction towards the substrate once the lid is in its final mounting position, and curing the liquid, semi-liquid or viscous material in order to form a casting compound.

## Description

### TECHNICAL FIELD

The instant disclosure relates to a method for producing a power semiconductor module, in particular to a method for producing a power semiconductor module comprising a casting compound.

### BACKGROUND

Power semiconductor modules often include a substrate arranged in a housing. A semiconductor arrangement including a plurality of controllable semiconductor elements (e.g., two IGBTs in a half-bridge configuration) may be arranged on the substrate. The substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer.

The housing may be partly filled with a casting compound to protect the components and electrical connections inside the power semiconductor module, in particular inside the housing, from certain environmental conditions, mechanical damage and insulation faults. When the casting compound is formed, usually a liquid, semi-liquid or viscous material is poured into the housing, thereby forming a liquid or viscous pre-layer. A heating step may follow during which liquid that is present in the pre-layer is at least partly evaporated. In this way, the pre-layer is hardened to form the resulting casting compound. There is a risk that a lid of the housing is wetted by the material of the casting compound during the heating step. The material may then unintentionally leak out of the housing.

There is a need for a method for producing a semiconductor module arrangement that prevents the material of the casting compound from leaking out of the housing.

### SUMMARY

A method includes pouring a liquid, semi-liquid or viscous material into a cavity formed by sidewalls of a housing, thereby covering a substrate that is arranged in the cavity formed by the sidewalls, arranging a lid on the sidewalls, thereby covering the cavity formed by the sidewalls, wherein the lid comprises at least one functional element that extends from the lid into the liquid, semi-liquid or viscous material in a direction towards the substrate once the lid is in its final mounting position, and curing the liquid, semi-liquid or viscous material in order to form a casting compound.

The invention may be better understood with reference to the following drawings and the description. The components in the figures are not necessarily to scale, emphasis instead being placed upon illustrating the principles of the invention. Moreover, in the figures, like reference numerals designate corresponding parts throughout the different views.

### BRIEF DESCRIPTION OF THE DRAWINGS

Figure 1 is a cross-sectional view of a power semiconductor module without a casting compound.
Figure 2 is a cross-sectional view of a power semiconductor module with a casting compound.
Figure 3 is a cross-sectional view of an example of a power semiconductor module with material of the casting compound leaking out of the housing during a heating step.
Figures 4 to 7 schematically illustrate subsequent steps of a method for forming a power semiconductor module arrangement according to one example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to designate different "elements". That is, e.g., the existence of a "third element" does not require the existence of a "first element" and a "second element". An electrical line or electrical connection as described herein may be a single electrically conductive element, or may include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or may be included in a semiconductor chip. A semiconductor body has electrically connecting pads and includes at least one semiconductor element with electrodes.

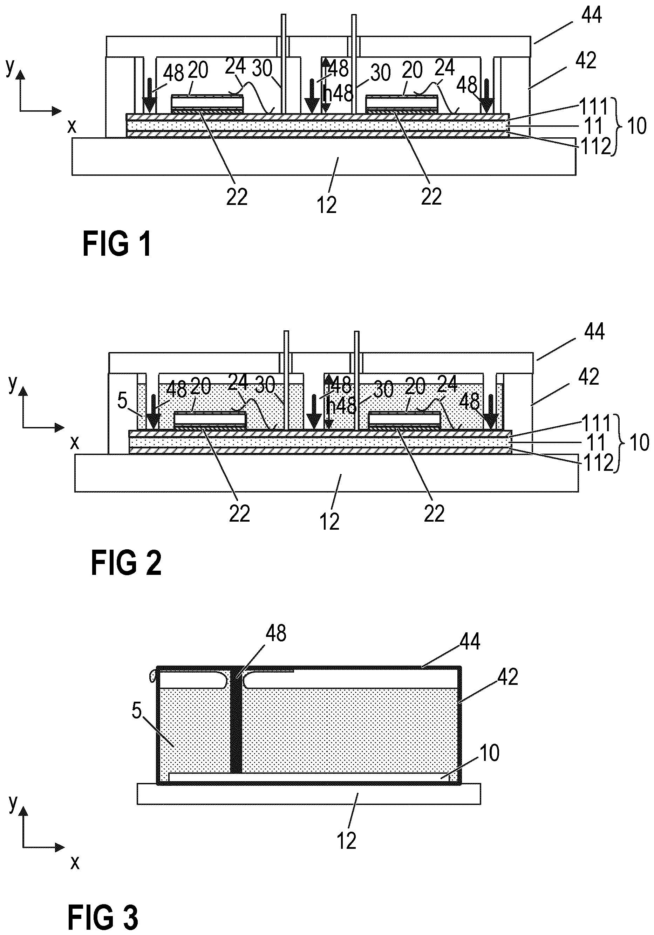

Referring to Figure 1, a cross-sectional view of an exemplary power semiconductor module is illustrated. The power semiconductor module includes a housing and a substrate 10. The substrate 10 includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112. It is, however, also possible that the substrate 10 only comprises a first metallization layer 111, and that the second metallization layer 112 is omitted.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may be, e.g., a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing. In the example illustrated in Figure 1, the substrate 10 is arranged on a ground surface 12 of the housing. The housing further comprises sidewalls 42 and a lid 44. The sidewalls 42 and the lid 44 are separate elements. That is, when assembling the power semiconductor module arrangement, the sidewalls 42 may be arranged on the substrate and/or the ground surface 12 first, with the lid still being open. The lid 44 may only be mounted on the sidewalls 42 at a later stage during the assembly. In some examples, the ground surface 12 of the housing may be omitted. In such cases the substrate 10 itself may form the ground surface of the housing. The substrate 10 may also be arranged on a base plate or heat sink 12, for example. In the example in Figure 1, only one substrate 10 is arranged on the ground surface, base plate or heat sink 12 (only referred to as ground surface in the following). In some power semiconductor module arrangements, more than one substrate 10 may be arranged in a single housing. The ground surface 12, the sidewalls 42 and the lid 44 may include a metal or a metal alloy, for example. It is, however, also possible that the ground surface 12, sidewalls 42 and lid 44 comprise an electrically insulating material such as a plastic or ceramic material, for example. The housing may also include a liquid crystal polymer, for example. Other materials are also possible. In the examples illustrated herein, the housing is rectangular or has a square shape and has four sidewalls 42. This, however, is only an example. It is generally possible that the housing comprises any number of sidewalls (e.g., three, four, or even more). The number of sidewalls is not relevant for the present invention.

The substrate 10 may be connected to the ground surface 12 by means of a connection layer (not specifically illustrated in Figure 1). Such a connection layer may be a solder layer, a layer of an adhesive material, or a layer of a sintered metal powder, e.g., a sintered silver powder, for example. Any other kind of electrically conducting or non-conducting connection layer is also possible.

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 of the example in Figure 1 is also a continuous layer. However, the first metallization layer 111, or the second metallization layer 112, or both can also be structured layers. "Structured layer" means that, e.g., the respective metallization layer 111, 112 is not a continuous layer, but includes recesses between different sections of the layer. Different semiconductor bodies 20 may be mounted to the same or to different sections of the first metallization layer 111. Different sections of the first metallization layer 111 may have no electrical connection or may be electrically connected to one or more other sections using, e.g., bonding wires. Electrical connections may also include bonding ribbons, connection plates or conductor rails, for example, to name just a few examples. According to another example, the second metallization layer 112 can be omitted altogether. The one or more semiconductor bodies 20 may be electrically and mechanically connected to the substrate 10 by an electrically conductive connection layer 22. Such an electrically conductive connection layer 22 may be a solder layer, a layer of an electrically conductive adhesive, or a layer of a sintered metal powder, e.g., a sintered silver powder, for example.

The power semiconductor module may further include terminal elements 30. The terminal elements 30 are electrically connected to the substrate 10, e.g., to the first metallization layer 111 of the substrate 10, and form a contact element which provides an electrical connection between the inside and the outside of the housing. The terminal elements 30 may extend through the housing as shown in Figures 1 and 2, or they may be formed as part of the housing, and connected electrically to the substrate 10 via further conductors without being in direct physical contact with the substrate 10. A first end of the terminal elements 30 may be electrically and mechanically connected to the first metallization layer 111 by an electrically conductive connection layer (not specifically illustrated). Such an electrically conductive connection layer may be a solder layer, a layer of an electrically conductive adhesive, or a layer of a sintered metal powder, e.g., a sintered silver powder, for example. A second end of the terminal elements 30 protrudes out of the housing to allow the terminal element 30 to be electrically contacted from the outside. The lid 44 may comprise through holes or openings through which the terminal elements 30 may protrude such that their first end is inside the housing and their second end is outside the housing. The terminal elements 30 may protrude vertically (i.e., perpendicular to a top surface of the substrate 10) out of the housing when the housing is arranged to surround the substrate 10. According to another example, terminal elements 30 may also protrude horizontally (parallel to the top surface of the substrate 10) through a sidewall 42 of the housing.

The semiconductor module arrangement illustrated in Figure 1 further comprises press-on pins 48. The press-on pins 48 are attached to the lid 44 and extend vertically from the lid 44 towards the substrate 10. The press-on pins 48 contact the substrate 10, for example. In Figure 1, the press-on pins 48 are illustrated as being arranged at a certain distance from the different semiconductor bodies 20 in a horizontal direction x. This, however, is only an example. Generally, press-on pins 48 may also be arranged in close vicinity to at least one of the semiconductor bodies 20. According to another example, press-on pins 48 may contact a semiconductor body 20 instead of on the substrate 10. If the press-on pin 48 contacts a semiconductor body 20, the respective semiconductor body 20 is arranged between the press-on pin 48 and the substrate 10. The press-on pin 48 may be arranged at a central position within the housing. That is, the press-on pin 48 may be arranged at a first distance from a first sidewall and at a second distance from a second sidewall opposite the first sidewall, wherein the first distance equals the second distance, and at a third distance from a third sidewall and at a fourth distance from a fourth sidewall opposite the third sidewall, wherein the third distance equals the fourth distance. Press-on pins, however, may also be arranged at any other suitable position within the housing.

When the semiconductor module arrangement is fully assembled, the substrate 10 is pressed onto the ground surface 12 of the housing by means of the press-on pins 48 in order to reduce a thermal resistance between the substrate 10 and the ground surface 12. Further, the substrate 10 is thereby kept in a desired position and is prevented from shifting inside the housing. When the lid 44 is arranged on the sidewalls 42 to close the housing, the press-on pins 48 contact the substrate 10 or one of the semiconductor bodies 20 and exert a pressure on the press-on pins 48. The bold arrows in Figure 1 illustrate a direction in which the lid 44 is moved while closing the housing and a direction of the pressure exerted on the press-on pin 48 once the housing is fully closed.

In the example illustrated in Figure 1, the power semiconductor module arrangement comprises a plurality of terminal elements 30 and a plurality of press-on pins 48. This, however, is only an example. Generally, a power semiconductor module arrangement may comprise at least one functional element, the at least one functional element comprising at least one terminal element and/or at least one press-on pin 48. The term "functional element" as used herein refers to any element extending from the lid 44 of the housing in a vertical direction towards the substrate 10 that exhibits at least one specific function within the power semiconductor module arrangement. The terminal elements, for example, fall under the term functional element as they are configured to conduct currents / voltages and to transmit signals between the inside and the outside of the housing. The press-on pins 48 are used to press the substrate 10 towards the ground surface 12, and are therefore functional elements. There may be, however, any other kinds of functional elements that exhibit other functions and that extend from the lid 44 towards the substrate 10. Such functional elements do not necessarily extend all the way towards the substrate. It is generally also possible that a functional element does not directly contact the substrate 10 or any of the elements mounted thereon.

Many power semiconductor modules further include a casting compound 5, as is illustrated in the example of Figure 2. The casting compound 5 may consist of or include a silicone gel or may be a rigid molding compound, for example. The casting compound 5 may partly fill the interior of the housing, thereby covering the substrate 10 and the semiconductor bodies 20, and any other components and electrical connections 24 that are arranged on the substrate 10. Electrical connections 24 such as, e.g., bonding wires or bonding ribbons, may electrically couple the semiconductor bodies 20 to the first metallization layer 111, to other semiconductor bodies 20, or to any other components that may be arranged inside the housing. The terminal elements 30 may be partly embedded in the casting compound 5. At least the second ends of the terminal elements 30, however, may not be covered by the casting compound 5 and may protrude from the casting compound 5. The same applies for the press-on pins 48. The casting compound 5 is configured to protect the components and electrical connections inside the power semiconductor module arrangement, in particular inside the housing, from certain environmental conditions, mechanical damage and insulation faults.

When the casting compound 5 is formed, usually a liquid, semi-liquid or viscous material is poured into the housing, thereby forming a liquid, semi-liquid or viscous pre-layer. Generally, it is possible that the lid 44 is already arranged on the sidewalls 42 at this point. The lid 44, for example, may comprise an opening through which the liquid, semi-liquid or viscous material may be poured into the housing. A heating step may follow during which liquid that is present in the pre-layer is at least partly evaporated. In this way, the pre-layer is hardened to form the resulting casting compound 5. The liquid, semi-liquid or viscous material is generally poured into the housing at room temperature. During the following heating step, the liquid, semi-liquid or viscous material is heated to temperatures of up to 120°C or even more. For example, the liquid, semi-liquid or viscous material of the pre-layer may be heated to temperatures of between 60°C and 120°C. When heat is applied to the liquid, semi-liquid or viscous material of the casting compound 5, liquid that is present in the pre-layer evaporates and a cross-linking process is started. After a certain time, e.g., 10 to 20 minutes, the material is sufficiently cured, thereby forming the resulting casting compound 5.

During the heating step, the liquid, semi-liquid or viscous material expands to a certain degree, due to the high temperatures. As has been described above, certain functional elements such as, e.g., the terminal elements 30 or the press-on pins 48, extend from the lid 44 of the housing toward the substrate 10. A part of such functional elements, therefore, is embedded in the liquid, semi-liquid or viscous material of the pre-layer, while another part of the functional elements extends out of the liquid, semi-liquid or viscous material and further towards the lid 44. This may be the case for other functional elements of the power semiconductor module as well. There is a risk, however, that when the material expands during the heating step, and further under the influence of, e.g., a capillary or any other effects, the material creeps along such functional elements in a vertical direction y to the inner surface of the lid 44, the inner surface of the lid 44 being a surface facing towards the substrate 10. In this way, the inner surface of the lid 44 may be wetted by the material of the pre-layer. If a certain amount of material collects on the inner surface of the lid 44, it may further creep along the lid 44 towards the sidewalls 42. There it may unintentionally leak out of the housing, especially at the beginning of the heating step when the material is not yet sufficiently cross-linked and hardened. The leaking of material out of the housing is schematically illustrated in the arrangement illustrated in Figure 3. The material wetting the lid 44 and leaking out of the housing may negatively affect the performance and the lifetime of the power semiconductor module.

In order to prevent the material of the pre-layer that is supposed to form the casting compound 5 from wetting the inside of the lid 44 and from leaking out of the housing, instead of mounting the lid 44 on the sidewalls 42 before filling the liquid, semi-liquid or viscous material of the pre-layer into the housing, the liquid, semi-liquid or viscous material of the pre-layer is filled into the housing first, and only then the lid 44 is arranged on the sidewalls 42. The lid 44, however, is arranged on the sidewalls 42 before hardening the liquid, semi-liquid or viscous material of the pre-layer. The functional elements, therefore, are immersed into the liquid, semi-liquid or viscous material of the pre-layer while mounting the lid 44 on the sidewalls 42. The functional elements displace the liquid, semi-liquid or viscous material of the pre-layer to a certain degree. That is, after mounting the lid 44 on the sidewalls, a height of the liquid, semi-liquid or viscous material of the pre-layer in the vertical direction y above the substrate 10 increases to a certain degree. The increase in height may be marginal, if there are only few functional elements and/or only small functional elements of comparably small volume. The increase in height may be somewhat more if there are many functional elements and/or large functional elements of a larger volume.

When the lid 44 is arranged on the sidewalls 42 after filling the liquid, semi-liquid or viscous material of the pre-layer into the housing, the effect of material creeping along the functional elements toward the inner surface of the lid 44 and from there leaking out of the housing may be significantly reduced or even completely prevented. The vertical insertion of the functional elements into the liquid, semi-liquid or viscous material of the pre-layer has significant influence on the capillary or any other effects. While the capillary effect or other effects occur in those cases in which the liquid, semi-liquid or viscous material of the pre-layer is filled into the housing after the lid 44 has been arranged on the sidewalls, such effects may be reduced or even entirely avoided by arranging the lid 44 on the sidewalls 42 after filling the liquid, semi-liquid or viscous material of the pre-layer into the housing.

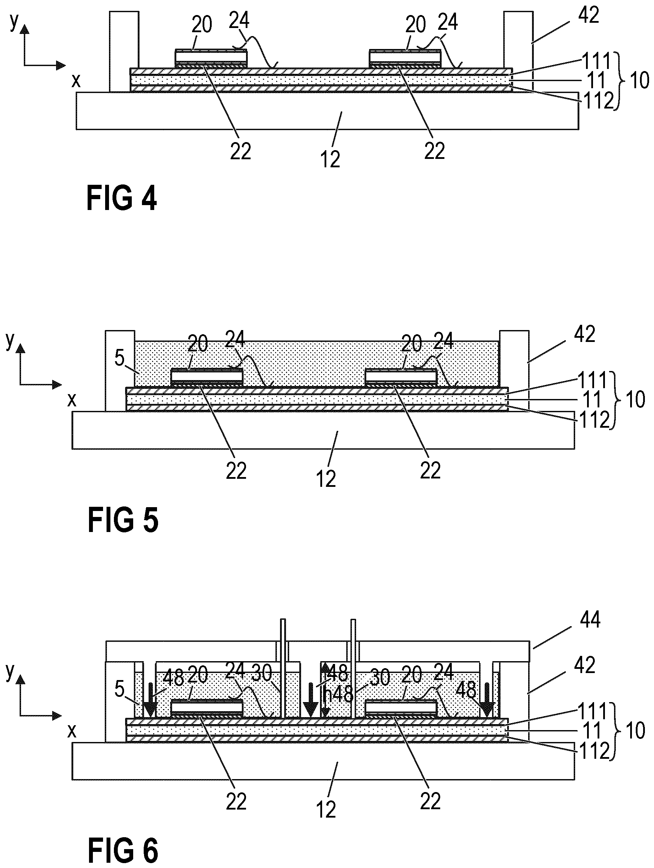

Now referring to Figures 4 to 7, an exemplary method is schematically illustrated. As is illustrated in Figure 4, the substrate 10 (with semiconductor bodies 20 and other elements and components mounted thereon) is arranged on a ground surface 12. The sidewalls 42 are arranged to surround the substrate 10. In a following step, which is schematically illustrated in Figure 5, the liquid, semi-liquid or viscous material of the pre-layer is filled into the housing (i.e. into the cavity formed by the sidewalls 42) to cover the substrate 10 and the components mounted thereon. The liquid, semi-liquid or viscous material of the pre-layer, however, does not completely fill the cavity formed by the sidewalls 42. At least part of the cavity remains free from the liquid, semi-liquid or viscous material of the pre-layer.

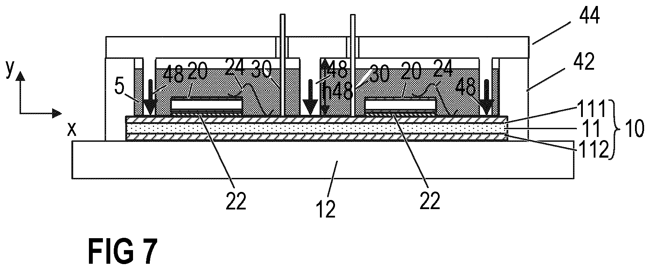

Now referring to Figure 6, the lid 44 with the functional elements attached thereto is mounted on the sidewalls 42. A volume that is not filled with the liquid, semi-liquid or viscous material of the pre-layer remains between the liquid, semi-liquid or viscous material of the pre-layer and the inner surface of the lid 44. That is, the inner surface of the lid 44 is not in direct contact with the liquid, semi-liquid or viscous material of the pre-layer. In a subsequent step, which is schematically illustrated in Figure 7, the liquid, semi-liquid or viscous material of the pre-layer is hardened/cured, thereby forming the final casting compound 5.

The method described with respect to Figures 4 to 7 has several further advantages. For example, the entire opening formed by the sidewalls 42 remains available during the step of filling the liquid, semi-liquid or viscous material of the pre-layer into the housing. That is, a position of a nozzle through which the liquid, semi-liquid or viscous material is injected into the housing may be freely chosen and is not restricted by a comparably small opening provided in the lid 44. It is even possible to use a plurality of nozzles at different positions. In this way, the liquid, semi-liquid or viscous material may be filled into the housing in a shorter time which results in decreased costs.

## Claims

1. A method comprising:
pouring a liquid, semi-liquid or viscous material into a cavity formed by sidewalls (42) of a housing, thereby covering a substrate (10) that is arranged in the cavity formed by the sidewalls (42);
arranging a lid (44) on the sidewalls (42), thereby covering the cavity formed by the sidewalls (42), wherein the lid (44) comprises at least one functional element that extends from the lid (44) into the liquid, semi-liquid or viscous material in a direction towards the substrate (10) once the lid (44) is in its final mounting position; and
curing the liquid, semi-liquid or viscous material in order to form a casting compound (5).

2. The method of claim 1, wherein the step of curing the liquid, semi-liquid or viscous material comprises heating the liquid, semi-liquid or viscous material to a temperature of between 60°C and 120°C.

3. The method of claim 2, wherein the liquid, semi-liquid or viscous material is heated to a temperature of between 60°C and 120°C for between 10 and 20 minutes.

4. The method of any of claims 1 to 3, wherein, when pouring the liquid, semi-liquid or viscous material into the cavity formed by the sidewalls (42), the cavity formed by the sidewalls (42) is only partly filled with the liquid, semi-liquid or viscous material such that, after arranging the lid (44) on the sidewalls (42), a cavity remains between the liquid, semi-liquid or viscous material and the lid (44).

5. The method of any of claims 1 to 4, wherein, the at least one functional element displaces the liquid, semi-liquid or viscous material of the pre-layer during the step of arranging the lid (44) on the sidewalls (42).

6. The method of any of claims 1 to 5, wherein the step of pouring a liquid, semi-liquid or viscous material into a cavity formed by sidewalls (42) of a housing comprises pouring a silicone gel into the cavity.

7. The method of any of the preceding claims, further comprising mounting at least one semiconductor body (20) on the substrate (10) before pouring the liquid, semi-liquid or viscous material into the cavity formed by the sidewalls.

## Amended claims

### Amended claims in accordance with Rule 137(2) EPC.

1. A method for producing a power semiconductor module, the method comprising:
pouring a liquid, semi-liquid or viscous material into a cavity formed by sidewalls (42) of a housing, thereby covering a substrate (10) that is arranged in the cavity formed by the sidewalls (42);
arranging a lid (44) on the sidewalls (42), thereby covering the cavity formed by the sidewalls (42), wherein the lid (44) comprises at least one functional element that extends from the lid (44) into the liquid, semi-liquid or viscous material in a direction towards the substrate (10) once the lid (44) is in its final mounting position, wherein each of the at least one functional element is an element extending from the lid (44) of the housing in a vertical direction towards the substrate (10), and exhibiting at least one specific function within the power semiconductor module arrangement; and
curing the liquid, semi-liquid or viscous material in order to form a casting compound (5),
wherein the step of arranging the lid (44) on the sidewalls (42) is performed after the liquid, semi-liquid or viscous material has been poured into the cavity.

2. The method of claim 1, wherein the step of curing the liquid, semi-liquid or viscous material comprises heating the liquid, semi-liquid or viscous material to a temperature of between 60°C and 120°C.

3. The method of claim 2, wherein the liquid, semi-liquid or viscous material is heated to a temperature of between 60°C and 120°C for between 10 and 20 minutes.

4. The method of any of claims 1 to 3, wherein, when pouring the liquid, semi-liquid or viscous material into the cavity formed by the sidewalls (42), the cavity formed by the sidewalls (42) is only partly filled with the liquid, semi-liquid or viscous material such that, after arranging the lid (44) on the sidewalls (42), a cavity remains between the liquid, semi-liquid or viscous material and the lid (44).

5. The method of any of claims 1 to 4, wherein the step of pouring a liquid, semi-liquid or viscous material into a cavity formed by sidewalls (42) of a housing comprises pouring a silicone gel into the cavity.

6. The method of any of the preceding claims, further comprising mounting at least one semiconductor body (20) on the substrate (10) before pouring the liquid, semi-liquid or viscous material into the cavity formed by the sidewalls.
